(19) **Europäisches Patentamt** / **European Patent Office** / **Office européen des brevets**

(11) **EP 1 837 918 A2**

(12) **EUROPÄISCHE PATENTANMELDUNG**

(43) Veröffentlichungstag:
26.09.2007 Patentblatt 2007/39

(51) Int Cl.:
*H01L 31/02* (2006.01)  *H01L 31/105* (2006.01)

(21) Anmeldenummer: 07003347.7

(22) Anmeldetag: 16.02.2007

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **23.03.2006 DE 102006013460**

(71) Anmelder: **Prüftechnik Dieter Busch AG**
**85737 Ismaning (DE)**

(72) Erfinder: **Lysen, Heinrich**
**85748 Garching (DE)**

(74) Vertreter: **Epping - Hermann - Fischer**
**Patentanwaltsgesellschaft mbH**
**Ridlerstrasse 55**
**80339 München (DE)**

(54) **Photodetektoranordnung, Messanordnung mit einer Photodetektoranordnung und Verfahren zum Betrieb einer Messanordnung**

(57)   Eine Photodetektoranordnung (1) umfasst einen Halbleiterkörper (2) mit einem Substrat (3), einer ersten Schicht (11) an einer ersten Hauptfläche (10) des Halbleiterkörpers (2) und einer zweiten Schicht (21) an einer zweiten Hauptfläche (20) des Halbleiterkörpers (2). Die zweite Hauptfläche (20) ist zu der ersten Hauptfläche (10) entfernt. Ein erster und ein zweiter Messanschluss (24, 25) sind an der zweiten Hauptfläche (20) auf der zweiten Schicht (21) randseitig in voneinander entfernt liegenden Bereichen angeordnet und sind zur elektrischen Kontaktierung der zweiten Schicht (21) von außerhalb des Halbleiterkörpers (2) ausgebildet. Ein erster und ein zweiter Transistor (45, 46) koppeln die zweite Schicht (21) mit dem ersten beziehungsweise dem zweiten Messanschluss (24, 25).

FIG. 1A

Printed by Jouve, 75001 PARIS (FR)

**Beschreibung**

Die vorliegende Erfindung betrifft eine Photodetektoranordnung, eine Messanordnung mit einer Photodetektoranordnung und ein Verfahren zum Betrieb einer Messanordnung.

Photodetektoranordnungen werden beispielsweise zur Bestimmung einer Position des Auftreffortes eines Lichtstrahls eingesetzt. Dabei werden PN-Dioden und PIN-Dioden verwendet.

Das Dokument WO 84/04960 zeigt einen positionssensitiven Detektor in einer Vorrichtung zum Feststellen von Fluchtungsfehlern hintereinander angeordneter Wellen.

Die Dokumente EP 0513444 A1, US 4,874,939, US 4,887,140 und US 2004/0135224 A1 beschreiben positionssensitive Detektoren.

Aufgabe der vorliegenden Erfindung ist es, eine Photodetektoranordnung, eine Messanordnung mit der Photodetektoranordnung und ein Verfahren zum Betrieb einer Messanordnung bereitzustellen, die ein Schalten eines Messstroms in der Photodetektoranordnung ermöglichen.

Diese Aufgabe wird mit den Gegenständen der Patentansprüche 1 und 15 sowie dem Verfahren gemäß Patentanspruch 18 gelöst. Weiterbildungen und Ausgestaltungen sind jeweils Gegenstand der abhängigen Ansprüche.

Erfindungsgemäß umfasst eine Photodetektoranordnung einen Halbleiterkörper mit einem Substrat, einer ersten sowie einer zweiten Schicht. Die erste Schicht ist an einer ersten Hauptfläche des Halbleiterkörpers und die zweite Schicht an einer zweiten Hauptfläche des Halbleiterkörpers angeordnet. Die zweite Hauptfläche liegt der ersten Hauptfläche gegenüber. Ein erster und ein zweiter Messanschluss sind mit der zweiten Schicht gekoppelt. Der erste und der zweite Messanschluss sind jeweils an einem umlaufenden Rand der zweiten Schicht in Bereichen angeordnet, die voneinander entfernt liegen. Ein erster Transistor ist zur elektrischen Kopplung der zweiten Schicht mit dem ersten Messanschluss vorgesehen. Entsprechend ist ein zweiter Transistor zur elektrischen Kopplung der zweiten Schicht mit dem zweiten Messanschluss angeordnet.

Der Halbleiterkörper ist zum Empfang einer einfallenden, zu detektierenden Lichtstrahlung geeignet. Die Lichtstrahlung erzeugt Elektronen-Loch-Paare, die vor allem in Raumladungszonen zur Leitfähigkeit beitragen. In einem ersten Betriebszustand sind der erste und der zweite Transistor leitend geschaltet, so dass ein erster und ein zweiter Messstrom durch die erste Schicht und das Substrat zu der zweiten Schicht und von dort über den ersten Transistor zu dem ersten Messanschluss beziehungsweise über den zweiten Transistor zu dem zweiten Messanschluss fließen. In einem zweiten Betriebszustand sind der erste und der zweite Transistor sperrend geschaltet.

Mit Vorteil kann somit bereits in der Photodetektoranordnung der erste und der zweite Messstrom ein- beziehungsweise ausgeschaltet werden.

In einer Ausführungsform sind ein dritter und ein vierter Messanschluss mit der zweiten Schicht gekoppelt, die ebenfalls zur elektrischen Kontaktierung der zweiten Schicht dienen. Der dritte und der vierte Messanschluss sind in zwei weiteren Bereichen nahe dem umlaufenden Rand der zweiten Schicht angeordnet, die voneinander entfernt liegen. Eine gedachte Verbindungslinie zwischen dem dritten und dem vierten Messanschluss und eine gedachte Verbindungslinie zwischen dem ersten und dem zweiten Messanschluss können sich in einem Winkel von näherungsweise 90 Grad kreuzen. Die beiden Verbindungslinien sind bevorzugt als Geraden ausgebildet.

Ein dritter und ein vierter Transistor können zur elektrischen Kopplung der zweiten Schicht mit dem dritten beziehungsweise dem vierten Messanschluss dienen. In dem ersten Betriebszustand, bei dem der erste und der zweite Transistor leitend sind, können der dritte und der vierte Transistor einen Strompfad von der zweiten Schicht zu dem dritten und dem vierten Messanschluss sperren. Dahingegen können in dem zweiten Betriebszustand, bei dem der erste und der zweite Transistor sperrend geschaltet sind, der dritte und der vierte Transistor leitend sein. Mit Vorteil ist durch die vier Transistoren erzielt, dass bereits in der Photodetektoranordnung ausgewählt wird, ob die Position des Auftreffortes eines Lichtstrahl zwischen dem ersten und dem zweiten Messanschluss oder die Position des Auftreffortes zwischen dem dritten und dem vierten Messanschluss ermittelt wird. Im ersten Betriebszustand kann somit eine x-Koordinate und im zweiten Betriebszustand eine y-Koordinate der Position des Auftreffortes ermittelt werden. Die vier Transistoren dienen somit als vier in der Photodetektoranordnung integrierte Schaltelemente, wobei die gesteuerten Strecken der vier Transistoren von dem Halbleiterkörper umfasst sind.

In einer Ausführungsform ist das Substrat als intrinsischer Halbleiter ausgebildet. Daher kann eine geringe Spannung zwischen der ersten und der zweiten Schicht ausreichend sein, um eine Raumladungszone in dem Substrat bereitzustellen.

Die erste Schicht kann als lichtdurchlässige Metallschicht, insbesondere als dünne Goldschicht, oder als lichtdurchlässige Halbleiterschicht, insbesondere als Indium-Zinn-Oxyd Schicht, ausgebildet sein. Alternativ weist die erste Schicht ein Material des Substrates auf und ist halbleitend ausgebildet. Der Halbleiterkörper kann ein halbleitendes Material wie Gallium-Arsenid, Indium-Gallium-Arsenid, Indium-Phosphit, Germanium, Quecksilber-Cadmium-Tellurid umfassen. Alternativ weist der Halbleiterkörper Silizium als Material auf.

In einer Ausführungsform weist die erste Schicht einen ersten Leitungstyp und die zweite Schicht einen zweiten Leitungstyp auf, welcher dem ersten Leitungstyp entgegengesetzt ist. Der erste Leitungstyp kann als ein P oder stark P dotiertes Halbleitermaterial und der zweite Leitungstyp als ein N oder stark N dotiertes Halbleitermaterial ausgebildet sein. Alternativ kann der erste Leitungstyp ein N oder stark N dotiertes und der zweite Leitungstyp als ein P oder stark P dotiertes Halbleitermaterial realisiert sein.

In einer anderen Ausführungsform weist die erste und die zweite Schicht den zweiten Leitungstyp auf. Gemäß dieser Ausführungsform ist eine dritte Schicht in dem Halbleiterkörper realisiert, die zwischen dem Substrat und der zweiten Schicht angeordnet ist. Die dritte Schicht weist den ersten Leitungstyp auf. Mit Vorteil kann mittels der dritten Schicht ein von einer Streustrahlung erzeugter Anteil der Messströme abgeleitet werden.

Der erste, der zweite, der dritte und der vierte Transistor können jeweils als Bipolar-Transistor realisiert sein. Mit Vorteil können die vier Transistoren jeweils als Feldeffekttransistor ausgebildet sein. Die vier Transistoren weisen je einen Steueranschluss zur elektrischen Kontaktierung auf.

Die vier Transistoren können jeweils einen Dotierungsbereich mit dem ersten Leitungstyp aufweisen. Dieser ist dem Leitungstyp der zweiten Schicht entgegengesetzt. Der Steueranschluss des jeweiligen Transistors ist an dem Dotierungsbereich angeschlossen. Entsprechend dem Potenzial an dem Steueranschluss kann eine Raumladungszone zwischen dem Dotierungsbereich und der zweiten Schicht eingestellt werden. Die Raumladungszone ist derart einstellbar, dass ein Strompfad zwischen der zweiten Schicht und dem jeweiligen Messanschluss mittels des Potenzials an dem Steueranschluss des Transistors in einem ersten Zustand leitend und in einem zweiten Zustand unterbrochen geschaltet sein kann. Die vier Transistoren können somit jeweils als Sperrschicht-Feldeffekttransistor, englisch Junction Field-Effect Transistor, realisiert sein.

In einer alternativen Ausführungsform weist der Steueranschluss einen unmittelbaren Kontakt ohne Zwischenschaltung einer weiteren Schicht mit der zweiten Schicht auf. Der Steueranschluss kann als Halbleiter, insbesondere in Form einer Polysiliziumschicht, Silizid- oder Metallschicht realisiert sein. Die vier Transistoren können somit als Metall-Halbleiter Feldeffekttransistor, abgekürzt MESFET, realisiert sein.

In einer weiteren alternativen Ausführungsform kann eine Gateisolatorschicht zwischen der zweiten Schicht und dem Steueranschluss eines der vier Transistoren vorgesehen sein. Die Gateisolatorschicht kann Siliziumdioxid umfassen. Die vier Transistoren können somit als Metall-Oxid-Halbleiter Feldeffekttransistor, abgekürzt MOSFET, realisiert sein.

In einer Ausführungsform nach dem vorgeschlagenen Prinzip kann eine Messanordnung die Photodetektoranordnung und eine Schaltungsanordnung aufweisen. Die Schaltungsanordnung ist mit einem Gesamtstromanschluss gekoppelt, der auf der ersten Schicht angeordnet ist und an dem ein erstes Potenzial bereitgestellt ist. Die Schaltungsanordnung ist mit dem ersten und dem zweiten Messanschluss der zweiten Schicht derart gekoppelt, dass an dem ersten beziehungsweise dem zweiten Messanschluss ein zweites beziehungsweise viertes Potenzial abgreifbar ist. Die Schaltungsanordnung weist einen Steuerausgang auf, der mit dem ersten Steueranschluss des ersten Transistors und dem zweiten Steueranschluss des zweiten Transistors gekoppelt ist. In einer Weiterbildung kann die Schaltungsanordnung an einem weiteren Steuerausgang mit dem dritten Steueranschluss des dritten Transistors und dem vierten Steueranschluss des vierten Transistors gekoppelt sein.

Im Falle des Fehlens der dritten Schicht im Halbleiterkörper kann das erste und das zweite Potential derart eingestellt sein, dass ein PN-Übergang zwischen der ersten und der zweiten Schicht in Sperrrichtung gepolt ist. Somit ist das zwischen der ersten und der zweiten Schicht befindliche Substrat von freien Ladungsträgern weitgehend frei und eine im Substrat absorbierte Photonenstrahlung erzeugt eine messbare Erhöhung der Ladungsträgerkonzentrationen im Substrat und erzielt damit den Detektorstrom.

Ist die dritte Schicht vorgesehen, so kann die dritte Schicht mit einem dritten Potenzial beaufschlagt werden. Das erste und das dritte Potential werden so eingestellt, dass ein PN-Übergang zwischen der ersten und der dritten Schicht in Sperrrichtung geschaltet ist. Das zweite und das dritte Potential können derart eingestellt sein, dass ein PN-Übergang zwischen der zweiten und der dritten Schicht in Sperrrichtung geschaltet ist.

In einer Weiterbildung weist die Schaltungsanordnung eine erste Strommessschaltung zur Ermittlung eines durch den ersten Messanschluss fließenden Stroms auf. Die erste Strommessschaltung kann als Strom-/Spannungsumsetzer realisiert sein, der eingangsseitig mit dem ersten Messanschluss verbunden ist. In einer Ausführungsform umfasst der Strom-/Spannungsumsetzer einen ersten Verstärker, der an einem ersten Eingang mit dem ersten Messanschluss, an einem zweiten Eingang mit einem Bezugspotentialanschluss und an einem Ausgang über eine erste Rückkoppelimpedanz mit dem ersten Eingang verbunden ist. Am Ausgang des ersten Verstärkers ist eine erste Ausgangsspannung bereitgestellt. In einer Weiterbildung weist die Schaltungsanordnung eine zweite, eine dritte und eine vierte Strommessschaltung auf, die mit dem zweiten, dem dritten beziehungsweise dem vierten Messanschluss verbunden ist. In einer Ausführungsform ist die jeweilige Strommessschaltung als Strom-/Spannungsumsetzer ausgebildet.

Die Messanordnung kann zur Bestimmung einer Position des Auftrefforts eines auf die Photodetektoranordnung auftreffenden Lichtstrahls entlang einer Koordinate eingesetzt werden. Sie kann alternativ zur Bestimmung einer x- und einer y-Koordinate der Position des Auftrefforts verwendbar sein. Die Messanordnung kann zum Feststellen von Fluchtungsfehlern hintereinander angeordneter Wellen eingesetzt werden. Es ist ein Vorteil der Photodetektoranordnung, dass die zweite Schicht etwa bei der Bestimmung der x-Koordinate von dem dritten und dem vierten Messanschluss entkoppelt werden kann, so dass die x-Koordinate sehr genau bestimmt werden kann. Entsprechend gilt dies auch für die Bestimmung der y-Koordinate.

Erfindungsgemäß sieht ein Verfahren zum Betrieb einer Messanordnung mit einer Photodetektoranordnung folgende Schritte vor: Die Photodetektoranordnung wird mit einem Lichtstrahl bestrahlt. Dadurch werden Elektronen-Loch-Paare in einem Halbleiterkörper der Photodetektoranordnung generiert. Die freien Elektronen und die freien Löcher werden in einem ersten Betriebszustand über einen ersten und einen zweiten Messanschluss abgeführt, dadurch dass ein erster und ein zweiter Transistor leitend geschaltet sind. In einem zweiten Betriebszustand werden die freien Elektronen und die freien Löcher nicht über den ersten und den zweiten Messanschluss abgeführt, da die beiden Transistoren sperrend geschaltet sind.

In einer Ausführungsform umfassen ein erster und ein zweiter Messstrom die freien Elektronen und die freien Löcher. Der erste und der zweiter Messstrom fließen bevorzugt vom ersten und vom zweiten Messanschluss durch den ersten beziehungsweise den zweiten Transistor, eine zweite Schicht des Halbleiterkörpers und ein Substrat des Halbleiterkörpers zu einer ersten Schicht des Halbleiterkörpers. Die erste Schicht ist an einer ersten Hauptfläche des Halbleiterkörpers und die zweite Schicht ist an einer zweiten Hauptfläche des Halbleiterkörpers angeordnet, die zur ersten Hauptfläche entfernt ist.

In einer Weiterbildung sind ein dritter und ein vierter Transistor zur Kopplung der zweiten Schicht mit einem dritten und einem vierten Messanschluss vorgesehen. Somit kann abwechselnd eine x-Koordinate oder eine y-Koordinate des Auftreffortes eines Lichtstrahls bestimmt werden. Sind in dem ersten Betriebszustand der dritte und der vierte Transistor sperrend geschaltet, so sind der dritte und der vierte Messanschluss nicht mit der zweiten Schicht gekoppelt und verzerren somit nicht die elektrischen Potenzialverhältnisse und die Stromlinien zwischen dem ersten und dem zweiten Messanschluss, sodass eine Genauigkeit der Positionsbestimmung verbessert ist.

Die Erfindung wird nachfolgend an mehreren Ausführungsbeispielen anhand der Figuren näher erläutert. Funktions- beziehungsweise wirkungsgleiche Schichten, Anordnungen und Bauelemente tragen gleiche Bezugszeichen. Insoweit sich Schichten, Anordnungen oder Bauelemente in ihrer Funktion entsprechen, wird deren Beschreibung nicht in jeder der folgenden Figuren wiederholt.

Figuren 1A und 1B     zeigen beispielhafte Ausführungsformen einer Photodetektoranordnung im Querschnitt nach dem vorgeschlagenen Prinzip,

Figuren 2A bis 2D     zeigen alternative beispielhafte Ausführungsformen einer Photodetektoranordnung mit Schaltungsanordnung nach dem vorgeschlagenen Prinzip und

Figur 3     zeigt eine beispielhafte Ausführungsform einer weiteren Schaltungsanordnung.

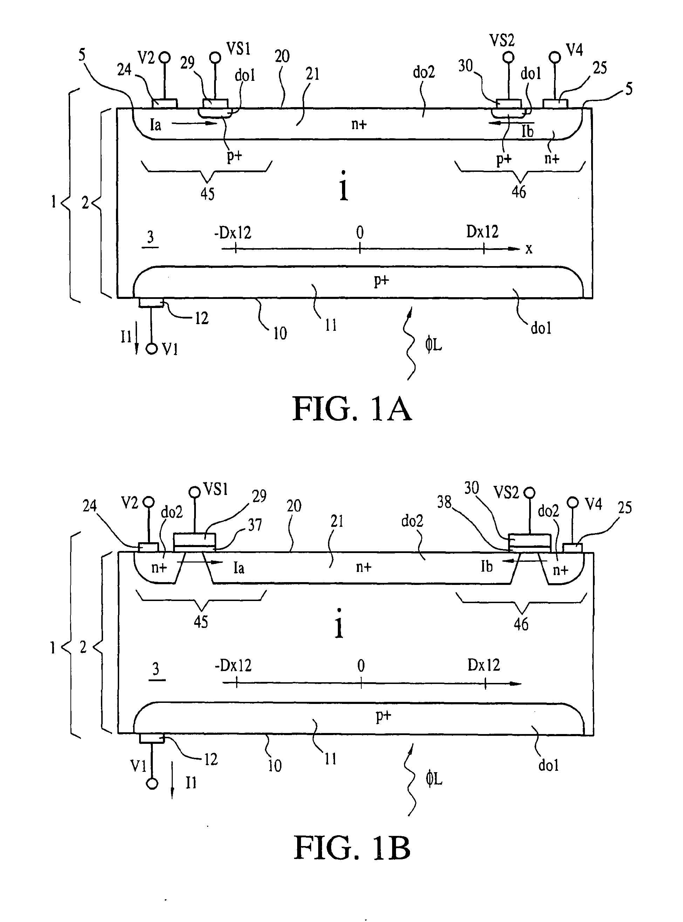

Figur 1A zeigt eine beispielhafte Ausführungsform einer Photodetektoranordnung 1 nach dem vorgeschlagenen Prinzip. Die Photodetektoranordnung 1 weist einen Halbleiterkörper 2 mit einem Substrat 3, einer ersten und einer zweiten Schicht 11, 21 auf. Die erste Schicht 11 ist an einer ersten Hauptfläche 10 und die zweite Schicht 21 an einer zweiten Hauptfläche 20 des Halbleiterkörpers 2 angeordnet. Die erste Hauptfläche 10 liegt zur zweiten Hauptfläche 20 entfernt. Ein Gesamtstromanschluss 12 ist mit der ersten Schicht 11 gekoppelt. Ein erster und ein zweiter Messanschluss 24, 25 sind mit der zweiten Schicht 21 gekoppelt und voneinander entfernt an einem umlaufenden Rand 5 der zweiten Schicht 21 angeordnet. Die erste Schicht 11 weist einen ersten Leitungstyp do1 auf und ist stark P dotiert. Die zweite Schicht 21 weist einen zweiten Leitungstyp do2 auf und ist stark N dotiert. Die zweite Schicht 21 weist bevorzugt einen Schichtwiderstand zwischen 1 und 9 kOhm pro Quadrat, englisch kOhm per square, auf. Zwei den ersten Leitungstyp do1 aufweisende Bereiche, die stark p dotiert sind, sind in der zweite Schicht 21 realisiert und mit einem ersten beziehungsweise einem zweiten Steueranschluss 29, 30 eines ersten beziehungsweise eines zweiten Transistors 45, 46 verbunden. Diese Verbindung ist elektrisch leitend ausgeführt. Der erste und der zweite Transistor 45, 46 koppeln die zweite Schicht 21 mit dem ersten beziehungsweise dem zweiten Messanschluss 24, 25. Sie sind jeweils als Sperrschicht-Feldeffekttransistor realisiert. Der Halbleiterkörper 2 weist Silizium als Material auf. Das Substrat 3 ist als eigenleitender Halbleiter ausgebildet.

An dem Gesamtstromanschluss 12 liegt ein erstes Potenzial V1 an. An dem ersten Messanschluss 24 ist ein zweites Potenzial V2 und an dem zweiten Messanschluss 25 ein viertes Potenzial V4 abgreifbar. Das erste Potenzial V1 ist kleiner als das zweite und das vierte Potenzial V2, V4. Somit ist das Substrat 3 als Raumladungszone ausgebildet. Der erste und der zweite Steueranschluss 29, 30 werden mit einer ersten und einer zweiten Steuerspannung VS1, VS2 beaufschlagt. Ist die erste Steuerspannung VS1 nahezu auf dem Wert des zweiten Potenzials V2 und die zweite Steuerspannung VS2 nahezu auf dem Wert des vierten Potenzials V4, so sind der erste und der zweite Transistor 45, 46 leitend. Die von einer Photonenstrahlung ΦL im Substrat 3 erzeugten Elektronen-Loch-Paare tragen somit zu einem Detektorstrom I1 bei, welcher über den Gesamtstromanschluss 12 abgeführt wird. Er teilt sich in einen ersten Messstrom Ia, der über den ersten Transistor 45 zu dem ersten Messanschluss 24 fließt, und in einen zweiten Messstrom Ib, der über den zweiten Transistor 46 zu dem zweiten Messanschluss 25 fließt, auf. Liegt in einem zweiten Betriebszustand ein erstes Steuerpotenzial VS1 auf einem deutlich niedrigeren Wert als das zweite Potenzial V2 und entsprechend das zweite Steuerpotenzial VS2 auf einem deutlich niedrigeren Wert als das vierte Potenzial V4, so sperren der erste und der zweite Transistor 45, 46. Mit Vorteil kann mit den beiden Transistoren 45, 46 ein Strompfad zu den beiden Messanschlüssen 24, 25 abwechselnd leitend oder sperrend geschaltet werden.

Figur 1B zeigt eine weitere beispielhafte Ausführungsform einer Photodetektoranordnung nach dem vorgeschlagenen Prinzip. Im Unterschied zu der Photodetektoranordnung 1 gemäß Figur 1A sind in der Photodetektoranordnung 1 gemäß Figur 1B der erste und der zweite Transistor 45, 46 als MOSFET ausgebildet. Der erste und der zweite Steueranschluss 29, 30 sind über einen ersten beziehungsweise einen zweiten Gateisolator 37, 38 mit dem Halbleiterkörper 2 gekoppelt. Die Sourcebereiche der beiden Transistoren 45, 46 sind mit dem ersten beziehungsweise dem zweiten Messanschluss 24, 25 verbunden, im Halbleiterkörper 2 angeordnet und weisen eine Dotierung mit dem zweiten Leitungstyp do2 wie die zweite Schicht 21 auf. In einem ersten Betriebszustand ist das erste und das zweite Steuerpotenzial VS1, VS2 auf Werte höher als eine Schwellspannung eingestellt, so dass eine Inversionsschicht aus Elektronen an der Grenze des ersten und des zweiten Gateisolators 37, 38 zu dem Halbleiterkörper 2 ausgebildet ist. Damit kann ein erster und ein zweiter Messstrom Ia, Ib von der zweiten Schicht 21 über die jeweilige Inversionsschicht zu dem ersten und dem zweiten Messanschluss 24, 25 fließen. Ist in einem zweiten Betriebszustand das erste und das zweite Steuerpotenzial VS1, VS2 auf einen Wert kleiner als die Schwellspannung eingestellt, so fließt kein Strom von der zweiten Schicht 21 zu dem ersten und dem zweiten Messanschluss 24, 25. Mit Vorteil können somit mittels der beiden Steuerpotenziale VS1, VS2 die beiden Transistoren 45, 46 abwechselnd leitend und sperrend geschaltet werden.

Alternativ können in den Photodetektoranordnungen 1 gemäß Figuren 1A und 1B Schichten mit dem ersten Leitungstyp do1 n-dotiert und Schichten mit dem zweiten Leitungstyp do2 p-dotiert sein.

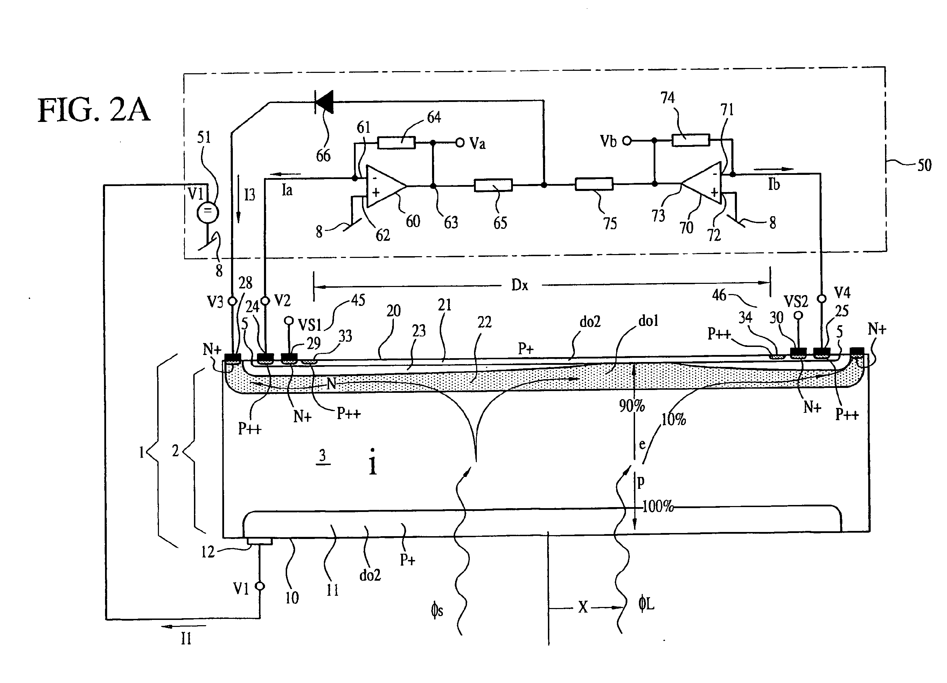

Figur 2A zeigt eine beispielhafte Ausführungsform einer Photodetektoranordnung 1 nach dem vorgeschlagenen Prinzip in Querschnittsdarstellung, die eine Weiterbildung der Photodetektoranordnungen 1 gemäß Figuren 1A und 1B ist, zusammen mit einer Schaltungsanordnung 50. Im Unterschied zu den Anordnungen nach den Figuren 1A und 1B umfasst der Halbleiterkörper 2 gemäß Figur 2A eine dritte Schicht 22, die zwischen der zweiten Schicht 21 und dem Substrat 3 vorgesehen ist und an den Rändern des gezeigten Ausschnitts des Halbleiterkörpers 2 mit der zweiten Hauptfläche 20 verbunden ist. Auf der dritten Schicht 22 ist ein Kompensationsanschluss 28 angeordnet. Der erste Transistor 45 umfasst einen ersten Steueranschluss 29 und einen ersten Drainbereich 33. Entsprechend umfasst der zweite Transistor 46 einen zweiten Steueranschluss 30 und einen zweiten Drainbereich 34. Die erste und die zweite Schicht 11, 21 weisen den zweiten Leitungstyp do2 auf und sind als P oder alternativ als stark P dotierte Schichten realisiert. Die dritte Schicht 22 weist den ersten Leitungstyp do1 auf und ist als N-dotierte Schicht ausgebildet.

Die Schaltungsanordnung 50 weist eine Spannungsquelle 51 auf, die mit dem Gesamtstromanschluss 12 verbunden ist. Weiter umfasst die Schaltungsanordnung 50 einen ersten Verstärker 60, der an einem ersten Eingang 61 mit dem ersten Messanschluss 24 und über eine erste Rückkoppelimpedanz 64 mit einem Ausgang 63 des Verstärkers 60 verbunden ist. Entsprechend weist die Schaltungsanordnung 50 einen zweiten Verstärker 70 auf, der an einem ersten Anschluss 71 mit dem zweiten Messanschluss 25 und über eine zweite Rückkoppelimpedanz 74 mit einem Ausgang 73 des Verstärkers 70 verbunden ist. Ein zweiter Eingang 62 des ersten Verstärkers 60 und ein zweiter Eingang 72 des zweiten Verstärkers 70 sind mit einem Bezugspotentialanschluss 8 verbunden. Der erste Eingang 61 ist invertierend gegenüber dem zweiten Eingang 62 des ersten Verstärkers 60 und der erste Eingang 71 des zweiten Verstärkers 70 ist invertierend gegenüber dem zweiten Eingang 72 geschaltet. Der Ausgang 63 des ersten Verstärkers 60 und der Ausgang 73 des zweiten Verstärkers 70 sind über eine erste beziehungsweise eine zweite Impedanz 65, 75 mit einem Knoten verbunden, der mittels einer Diode 66 mit dem Kompensationsanschluss 28 gekoppelt ist.

Mit dem Gesamtstromanschluss 12 wird die erste Schicht 11, mit dem ersten und dem zweiten Messanschluss 24, 25 die zweite Schicht 21 und mit dem Kompensationsanschluss 28 die dritte Schicht 22 kontaktiert. An dem Gesamtstromanschluss 12 ist ein erstes Potential V1, an dem ersten Messanschluss 24 ein zweites Potential V2, an dem zweiten Messanschluss 25 ein viertes Potential V4 und an dem Kompensationsanschluss 28 ein drittes Potential V3 bereitgestellt. Das zweite Potential V2 ist kleiner als das dritte Potential V3 eingestellt, so dass eine erste Raumladungszone 23 zwischen der zweiten und der dritten Schicht 21, 22 ausgebildet wird. Das erste Potential V1 ist kleiner als das dritte Potential V3 eingestellt, so dass das Substrat 3 zwischen der ersten Schicht 11 und der dritten Schicht 22 ebenfalls als Raumladungszone ausgebildet ist. Eine auf der Photodetektoranordnung 1 auftreffende Lichtstrahlung ΦL wird innerhalb des Halbleiterkörpers 2 absorbiert und erzeugt Elektronen-Loch-Paare. Elektronen e und Löcher p, die in dem Substrat 3 zwischen der ersten Schicht 11 und der dritten Schicht 22 generiert werden, tragen zu einem Detektorstrom I1 bei, der durch den Gesamtstromanschluss 12 fließt. Ein Wert des Detektorstroms I1 entspricht der Summe der Werte eines ersten Messstroms Ia, der durch den ersten Messanschluss 24 fließt, eines zweiten Messstroms Ib, der durch den zweiten Messanschluss 25 fließt, und eines Kompensationsstroms I3, der durch den Kompensationsanschluss 24 fließt. Die Spannungsquelle 51 stellt das erste Potential V1 bereit. Der erste und der zweite Verstärker 60, 70 dienen zur Umwandlung des ersten und des zweiten Messstroms Ia, Ib in eine erste beziehungsweise zweite Ausgangsspannung Va, Vb, die an den Ausgängen 63, 73 der beiden Verstärker 60, 70 bereitgestellt werden.

Trifft der Lichtstrahl ΦL die Photodetektoranordnung 1 näher an dem ersten Messanschluss 24 als an dem zweiten Messanschluss 25, so weist der erste Messstrom Ia einen höheren Wert als der zweite Messstrom Ib auf. Die x-Koordinate der Position des Auftreffortes des Lichtstrahls ΦL auf die Photodetektoranordnung 1 kann näherungsweise mit folgender Gleichung bestimmt werden:

$$x = \frac{Dx}{2} \frac{Ia - Ib}{Ia + Ib} = \frac{Dx}{2} \frac{Va - Vb}{Va + Vb} \quad,$$

wobei Ia und Ib der erste beziehungsweise der zweite Messstrom, Va und Vb die erste beziehungsweise die zweite Ausgangsspannung und Dx ein Abstand zwischen dem ersten und dem zweiten Drainbereich 33, 34 ist. Eine Streustrahlung Φs kann Elektronen-Loch-Paare erzeugen. Beispielhaft ist eine Streustrahlung ΦS mit der Leistung 0,01 mW eingezeichnet, die einem Strom in der Größenordnung von 1 μA in der dritten Schicht 22 entspricht. Ein Lichtstrahl ΦL mit einer Energie von beispielsweise 0,1 mW und einer Wellenlänge von beispielsweise 635 nm trifft ebenfalls auf die Photodetektoranordnung 1 und erzeugt Elektronen-Loch-Paare. Ein Verhältnis des Kompensationsstroms I3 zur Summe aus dem ersten und dem zweiten Messstrom Ia, Ib ist derart eingestellt, dass der Kompensationsstrom I3 dem durch die Streustrahlung Φs erzeugten Anteil im Detektorstrom I1 entspricht. Die erste und die zweite Rückkoppelimpedanz 64, 74 sowie die erste und die zweite Impedanz 65, 75 können als Widerstand ausgebildet sein. Die beiden Rückkoppelimpedanzen 64, 74 können beispielsweise einen Widerstandswert von 30 kOhm und die beiden Impedanzen 65, 75 einen Widerstandswert von 300 kOhm aufweisen, so dass der Kompensationsstrom I3 beispielsweise 10% des Wertes der Summe aus erstem und zweiten Messstrom Ia, Ib aufweist. Somit fließt der von der Streustrahlung Φs erzeugte Detektorstromanteil über den Kompensationsanschluss 28 ab. Dazu fließt der Kompensationsstrom I3 vom Ausgang 63 des ersten Verstärkers 60 über die erste Impedanz 65 und vom Ausgang 73 des zweiten Verstärkers 70 über die zweite Impedanz 75 zu der Diode 66 und damit zu dem Kompensationsanschluss 28. Die dritte Schicht 22 ist niedriger als die zweite Schicht 21 dotiert, so dass ein Hauptteil des Detektorstroms I1 durch die dritte Schicht 22 hindurch zur zweiten Schicht 21 fließt. Die dritte Schicht 22 weist bevorzugt einen Schichtwiderstand zwischen 10 und 100 kOhm pro Quadrat auf.

Der erste und der zweite Steueranschluss 29, 30 werden mit einem ersten beziehungsweise einem zweiten Steuerpotential VS1, VS2 beaufschlagt. Ist mittels des ersten und des zweiten Steuerpotentials VS1, VS2 der erste und der zweite Transistor 45, 46 in einen sperrenden Zustand geschaltet, so fließt der erste und der zweite Messstrom Ia, Ib nicht. Sind jedoch der erste und der zweite Transistor 45, 46 mittels des ersten und des zweiten Steuerpotentials VS1, VS2 leitend geschaltet, so kann mit Vorteil aus der Höhe des ersten und des zweiten Messstroms Ia, Ib eine x-Koordinate der Position des Auftreffortes des Lichtstrahls ΦL ermittelt werden. Mittels des Kompensationsstroms I3 kann vorteilhafterweise ein Einfluss der Streustrahlung ΦS verringert werden.

Alternativ können der erste und der zweite Drainbereich 33, 34 entfallen.

In einer alternativen Ausführungsform sind die erste Schicht 11 und die zweite Schicht 21 als N dotierter sowie die dritte Schicht 22 als P dotierter Bereich ausgebildet.

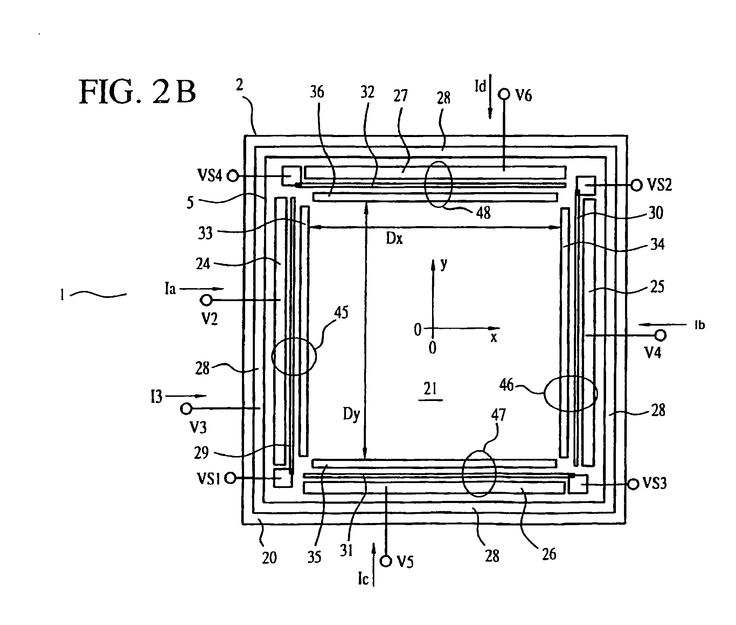

Figur 2B zeigt eine beispielhafte Ausführungsform der Photodetektoranordnung 1 gemäß Figur 2A in Aufsicht auf die zweite Hauptfläche 20. Die zweite Hauptfläche 20 weist die zweite Schicht 21 auf, die rechteckig, insbesondere quadratisch ausgebildet sein kann. Der erste Messanschluss 24 ist als Streifen entlang des Randes 5 der zweiten Schicht 21 realisiert. Entsprechend sind auch ein zweiter, ein dritter und ein vierter Messanschluss 25, 26, 27 jeweils als Streifen an dem Rand 5 der zweiten Schicht 21 vorgesehen. Die vier Messanschlüsse 24 bis 27 sind auf Rändern eines Rechteckes angeordnet. Der erste und der zweite Messanschluss 24, 25 sind voneinander entfernt angeordnet. Entsprechend sind der dritte und der vierte Messanschluss 26, 27 ebenfalls entfernt voneinander angeordnet. Eine gedankliche Verbindungslinie des ersten Messanschlusses 24 zum zweiten Messanschluss 25 kreuzt eine gedankliche Verbindungslinie des dritten Messanschlusses 26 zum vierten Messanschluss 27. Die vier Messanschlüsse 24 bis 27 sind jeweils elektrisch von außen kontaktiert, so dass ein zweites, ein viertes, ein fünftes beziehungsweise ein sechstes Potential V2, V4, V5, V6 an ihnen abgreifbar ist. Um die zweite Schicht 21 und damit um die vier Messanschlüsse 24 bis 27 herum ist streifenförmig der Kompensationsanschluss 28 vorgesehen, der elektrisch von außen zur Zuführung eines dritten Potentials V3 kontaktiert ist. Die Photodetektoranordnung 1 weist vier Transistoren 45 bis 48 auf. Der erste Transistor 45 umfasst den ersten Steueranschluss 29 und den ersten Drainbereich 33 und koppelt die zweite Schicht 21 mit dem ersten Messanschluss 24. Entsprechend sind der zweite, der dritte und der vierte Transistor 46, 47, 48 ausgebildet.

Wird der erste und der zweite Transistor 45, 46 in Durchlass und der dritte und der vierte Transistor 47, 48 sperrend geschaltet, kann mittels des ersten und des zweiten Messstroms Ia, Ib die x-Koordinate der Position des Auftreffens des Lichtstrahls ΦL ermittelt werden. Die y-Koordinate kann aus einem Wert des dritten Messstroms Ic und einem Wert des vierten Messstroms Id ermittelt werden, sobald der erste und der zweite Transistor 45, 46 sperrend und der dritte und der vierte Transistor 47, 48 leitend geschaltet sind.

Alternativ können die vier Drainbereiche 33 bis 36 entfallen.

Alternativ können die vier Drainbereiche 33 bis 36 im Halbleiterkörper 2 miteinander leitend verbunden sein, so dass sie als ein Streifen ausgebildet sind.

In einer alternativen Ausführungsform weist die Photodetektoranordnung 1 einen zweiten, einen dritten und einen vierten Kompensationsanschluss auf, die mit der dritten Schicht 22 gekoppelt und randseitig an der Photodetektoranordnung 1 in voneinander entfernten Bereichen angeordnet sind.

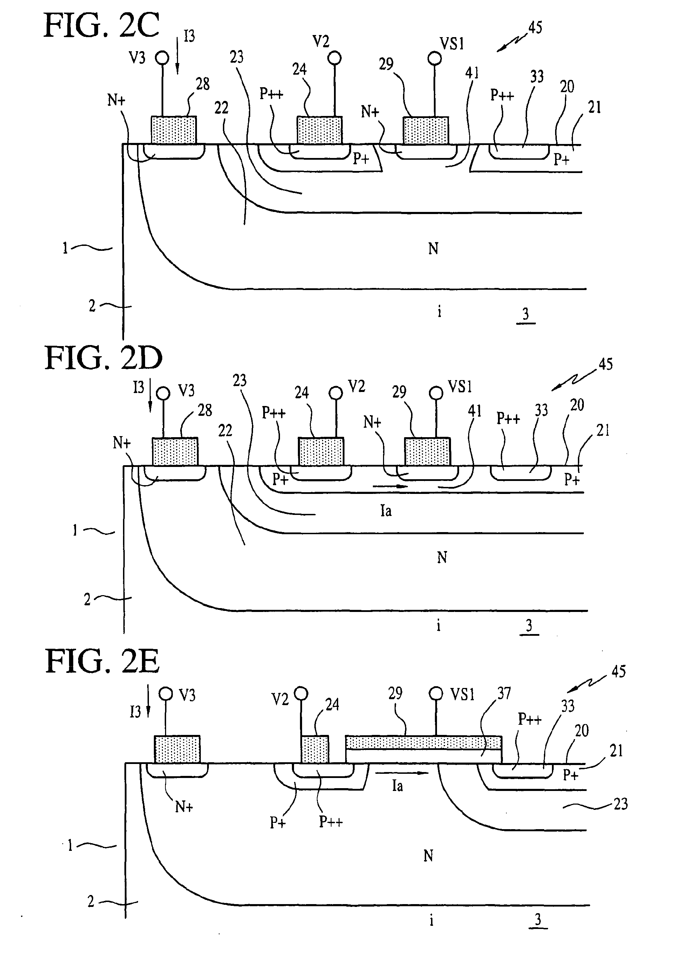

Figur 2C zeigt einen Ausschnitt aus der Photodetektoranordnung 1 gemäß Figur 2A. Der erste Transistor 45 ist gezeigt, welcher den ersten Messanschluss 24 mit der zweiten Schicht 21 koppelt. Dazu ist in dem Halbleiterkörper 2 unter dem ersten Messanschluss 24 ein sehr stark P dotiertes Gebiet, das in ein stark P dotiertes Gebiet übergeht, angeordnet, so dass der erste Messanschluss 24 einen ohmschen Kontakt zum Halbleiterkörper 2 aufweist. In der zweiten Schicht 21 ist randständig der erste Drainbereich 33 vorgesehen, der stark P dotiert ist. Unter dem ersten Steueranschluss 29 ist in dem Halbleiterkörper 2 ein stark N dotiertes Gebiet vorgesehen. Der Kompensationsanschluss 28 ist über ein stark N dotiertes Gebiet mit der N dotierten dritten Schicht 22 gekoppelt. Befindet sich das erste Steuerpotenzial VS1 auf einem höheren Potenzial als das zweite Potenzial V2, so ist der Halbleiterkörper 2 im Bereich 41 unterhalb des ersten Steueranschlusses 29 als Raumladungszone ausgebildet und der erste Transistor 45 sperrend geschaltet.

Figur 2D zeigt denselben Ausschnitt der Photodetektoranordnung 1 wie Figur 2C. Im Unterschied zu Figur 2C ist in Figur 2D das erste Steuerpotenzial VS1 näherungsweise auf demselben Wert wie das zweite Potenzial V2. Somit ist unter dem ersten Steueranschluss 29 in dem Bereich 41 keine Raumladungszone ausgebildet. Der erste Transistor 45 ist leitend geschaltet und ein Strompfad für den ersten Messstrom Ia von dem ersten Drainbereich 33 zu dem ersten Messanschluss 24 ist leitend.

Figur 2E zeigt den gleichen Ausschnitt der Photodetektoranordnung 1 wie die Figuren 2C und 2D. Im Unterschied zu den Figuren 2C und 2D ist in der Photodetektoranordnung 1 gemäß Figur 2E der erste Transistor 45 als MOSFET ausgebildet, der einen ersten Gateisolator 37 zwischen dem ersten Steueranschluss 29 und dem Halbleiterkörper 2 umfasst. Randständig ist in der zweiten Schicht 21 ein erster Drainbereich 33 realisiert, der stark P dotiert ist. Der Halbleiterkörper weist unter dem ersten Gateisolator 37 und damit zwischen dem Bereich unter dem ersten Messanschluss 24 und dem Drainbereich 33 einen N-dotierten Bereich auf. Befindet sich das erste Steuerpotenzial VS1 auf einem kleineren Wert als eine Schwellspannung, so wird eine Inversionsschicht aus Löchern in dem Halbleiterkörper 2 unter dem Gateisolator 37 ausgebildet. Über diese Inversionsschicht kann der erste Messstrom Ia von der zweiten Schicht 21 über den ersten Drainbereich 33 zu dem ersten Messanschluss 24 fließen. Weist das erste Steuerpotenzial VS2 einen Wert oberhalb einer Schwellspannung auf, so tritt keine Inversionsschicht auf und an dem ersten Messanschluss 24 ist kein erster Messstrom Ia abgreifbar. Der zweite, dritte und vierte Transistor 46, 47, 48 können entsprechend dem ersten Transistor 45 ausgebildet sein.

Alternativ ist kein erster Drainbereich 33 vorgesehen und die zweite Schicht 21 erstreckt sich bis unter den ersten Gateisolator 37.

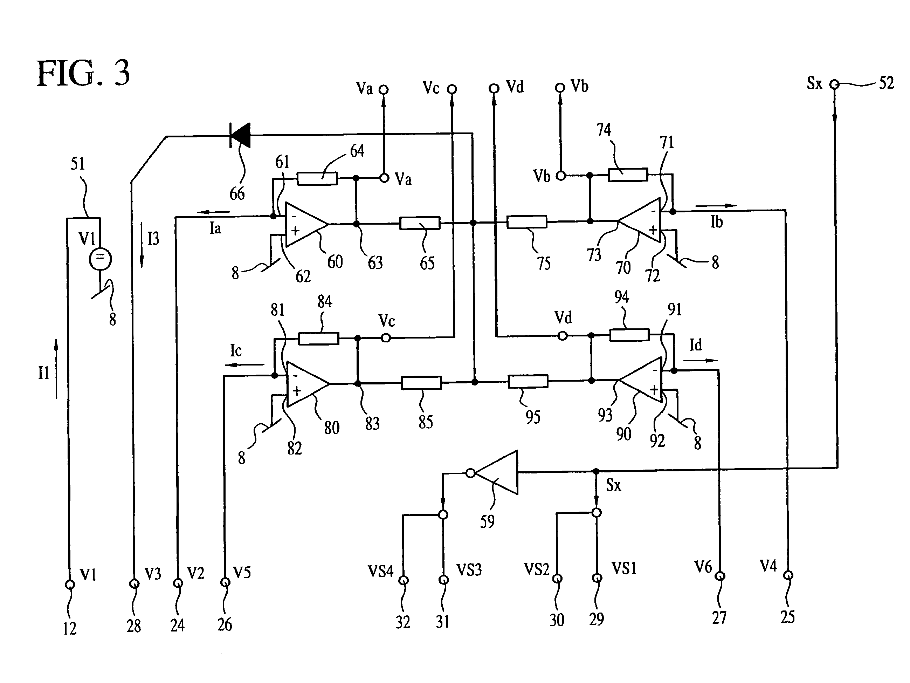

Figur 3 zeigt eine beispielhafte Ausführungsform einer Schaltungsanordnung 50, die eine Weiterbildung der Schaltungsanordnung gemäß Figur 2A darstellt. Zusätzlich zu der Schaltungsanordnung 50 gemäß Figur 2A weist die Schaltungsanordnung 50 gemäß Figur 3 einen Inverter 59 auf, der an einem Eingang mit einem Eingang 52 der Schaltungsanordnung 50 verbunden ist. Der erste und der zweite Steueranschluss 29, 30 sind an den Eingang des Inverters 59 und der dritte und der vierte Steueranschluss 31, 32 sind an einen Ausgang des Inverters 59 angeschlossen. Weiter weist die Schaltungsanordnung 50 einen dritten und einen vierten Verstärker 80, 90 auf, die mit dem dritten beziehungsweise vierten Messanschluss 26, 27 eingangsseitig verbunden sind und an ihrem Ausgang ein drittes beziehungsweise viertes Ausgangssignal Vc, Vd bereitstellen.

An dem Eingang 52 der Schaltungsanordnung 50 wird ein Taktsignal Sx zugeführt. Mittels des Inverters 59 wird erreicht, dass der erste und der zweite Transistor 45, 46 abwechselnd mit dem dritten und dem vierten Transistor 47, 48 sperrend beziehungsweise leitend geschaltet sind.

Die y-Koordinate kann näherungsweise gemäß folgender Gleichung ermittelt werden:

$$y = \frac{Dy}{2} \frac{Ic - Id}{Ic + Id} = \frac{Dy}{2} \frac{Vc - Vd}{Vc + Vd} \; ,$$

wobei Ic der dritte und Id der vierte Messstrom, Vc die dritte und Vd die vierte Ausgangsspannung sowie Dy ein Abstand zwischen dem dritten und dem vierten Drainbereich 26, 27 sind.

In einer alternativen Ausführungsform weist die Schaltungsanordnung eine Stromaufteilungsschaltung auf, die die Diode 66 mit dem ersten, einem zweiten, einem dritten und einem vierten Kompensationsanschluss koppelt. Die Stromaufteilungsschaltung kann vier Widerstände umfassen, die an einem ersten Anschluss mit der Diode 66 und an einem zweiten Anschluss mit jeweils einem der vier Kompensationsanschlüsse verbunden sind. Die Widerstände können näherungsweise den gleichen Wert aufweisen, so dass der Wert eines Stromes, der jeweils durch einen der vier Kompensationsanschlüsse fließt, näherungsweise gleich sein kann.

Bezugszeichenliste

| | |
|---|---|
| 1 | Photodetektoranordnung |
| 2 | Halbleiterkörper |
| 3 | Substrat |
| 5 | Rand |
| 10 | erste Hauptfläche |
| 11 | erste Schicht |
| 12 | Gesamtstromanschluss |
| 20 | zweite Hauptfläche |
| 21 | zweite Schicht |
| 22 | dritte Schicht |
| 23 | erste Raumladungszone |
| 24 | erster Messanschluss |
| 25 | zweiter Messanschluss |
| 26 | dritter Messanschluss |
| 27 | vierter Messanschluss |
| 28 | Kompensationsanschluss |
| 29 | erster Steueranschluss |
| 30 | zweiter Steueranschluss |
| 31 | dritter Steueranschluss |
| 32 | vierter Steueranschluss |
| 33 | erster Drainbereich |
| 34 | zweiter Drainbereich |
| 35 | dritter Drainbereich |
| 36 | vierter Drainbereich |
| 37 | erster Gateisolator |
| 38 | zweiter Gateisolator |
| 39 | dritter Gateisolator |
| 40 | vierter Gateisolator |
| 41 | Bereich |
| 45 | erster Transistor |
| 46 | zweiter Transistor |
| 47 | dritter Transistor |
| 48 | vierter Transistor |
| 50 | Schaltungsanordnung |
| 51 | Spannungsquelle |
| 52 | Eingang |
| 59 | Inverter |
| 60 | erster Verstärker |
| 61 | erster Eingang |
| 62 | zweiter Eingang |
| 63 | Ausgang |
| 64 | erste Rückkoppelimpedanz |
| 65 | erste Impedanz |
| 66 | Diode |
| 70 | zweiter Verstärker |
| 71 | erster Eingang |
| 72 | zweiter Eingang |

| | |
|---|---|
| 73 | Ausgang |
| 74 | zweite Rückkoppelimpedanz |
| 75 | zweite Impedanz |
| 80 | dritter Verstärker |
| 81 | erster Eingang |
| 82 | zweiter Eingang |
| 83 | Ausgang |
| 84 | dritte Rückkoppelimpedanz |
| 85 | dritte Impedanz |
| 90 | vierter Verstärker |
| 91 | erster Eingang |
| 92 | zweiter Eingang |
| 93 | Ausgang |
| 94 | vierte Rückkoppelimpedanz |
| 95 | vierte Impedanz |
| ΦL | Photonenstrahlung |
| Φs | Streustrahlung |
| do1 | erster Leitungstyp |
| do2 | zweiter Leitungstyp |
| Dx | Abstand in x-Richtung |
| Dy | Abstand in y-Richtung |
| e | Elektron |
| I1 | Detektorstrom |
| I3 | Kompensationsstrom |
| Ia | erster Messstrom |
| Ib | zweiter Messstrom |
| Ic | dritter Messstrom |
| Id | vierter Messstrom |
| N | negativ dotiert |
| P | positiv dotiert |
| p | Loch |
| Sx | Taktsignal |
| Va | erste Ausgangsspannung |
| Vb | zweite Ausgangsspannung |
| Vc | dritte Ausgangsspannung |
| Vd | vierte Ausgangsspannung |
| V1 | erstes Potential |
| V2 | zweites Potential |
| V3 | drittes Potential |
| V4 | viertes Potential |
| V5 | fünftes Potential |
| V6 | sechstes Potential |
| VS1 | erstes Steuerpotential |
| VS2 | zweites Steuerpotential |
| VS3 | drittes Steuerpotential |
| VS4 | viertes Steuerpotential |
| x, y | Koordinate |

**Patentansprüche**

1. Photodetektoranordnung,
   umfassend einen Halbleiterkörper (2) mit

   - einem Substrat (3),
   - einer ersten Schicht (11) an einer ersten Hauptfläche (10) des Halbleiterkörpers (2), der zum Empfang einer einfallenden, zu detektierenden Photonenstrahlung (ΦL) geeignet ist, und
   - einer zweiten Schicht (21) an einer zweiten Hauptfläche (20) des Halbleiterkörpers (2), die zu der ersten Hauptfläche (10) entfernt ist,
- einem ersten und einem zweiten Messanschluss (24, 25), die an der zweiten Hauptfläche (20) auf der zweiten Schicht (21) randseitig in voneinander entfernt liegenden Bereichen angeordnet sind und zur elektrischen Kontaktierung der zweiten Schicht (21) von außerhalb des Halbleiterkörpers (2) ausgebildet sind, sowie
- einem ersten und einem zweiten Transistor (45, 46) zur elektrischen Kopplung der zweiten Schicht (21) mit dem ersten beziehungsweise dem zweiten Messanschluss (24, 25).

2. Photodetektoranordnung nach Anspruch 1,
**dadurch gekennzeichnet, dass**
die Photodetektoranordnung (1) umfasst:

- einen dritten und einen vierten Messanschluss (26, 27), die zur elektrischen Kontaktierung der zweiten Schicht (21) von außerhalb des Halbleiterkörpers (2) ausgebildet sind und an der zweiten Hauptfläche (20) auf der zweiten Schicht (21) randseitig in zwei weiteren voneinander entfernt liegenden Bereichen derart angeordnet sind, dass sich eine gedachte Verbindungslinie von dem dritten zu dem vierten Messanschluss (26, 27) und eine gedachte Verbindungslinie von dem ersten zu dem zweiten Messanschluss (24, 25) kreuzen, und
- einen dritten und einen vierten Transistor (47, 48) zur elektrischen Kopplung der zweiten Schicht (21) mit dem dritten beziehungsweise dem vierten Messanschluss (26, 27) .

3. Photodetektoranordnung nach Anspruch 1 oder 2,
**dadurch gekennzeichnet, dass**
das Substrat (3) als intrinsischer Halbleiter ausgebildet ist.

4. Photodetektoranordnung nach einem der Ansprüche 1 bis 3,
**dadurch gekennzeichnet, dass**
die zweite Schicht (21) hochohmig ausgebildet ist.

5. Photodetektoranordnung nach einem der Ansprüche 1 bis 4,
**dadurch gekennzeichnet, dass**
die zweite Schicht (21) einen Schichtwiderstand zwischen 1 und 9 kOhm/Quadrat aufweist.

6. Photodetektoranordnung nach einem der Ansprüche 1 bis 5,
**dadurch gekennzeichnet, dass**

- die erste Schicht (11) einen ersten Leitungstyp (do1) aufweist und
- die zweite Schicht (21) einen zweiten Leitungstyp (do2) aufweist, welcher dem ersten Leitungstyp (do1) entgegengesetzt ist.

7. Photodetektoranordnung nach einem der Ansprüche 1 bis 5,
**dadurch gekennzeichnet, dass**

- die erste Schicht (11) einen zweiten Leitungstyp (do2) aufweist,
- die zweite Schicht (21) den zweiten Leitungstyp (do2), aufweist und
- eine dritte Schicht (22) in dem Halbleiterkörper (2) vorgesehen ist, die zwischen dem Substrat (3) und der zweiten Schicht (21) angeordnet ist und einen ersten Leitungstyp (do1) aufweist, welcher dem zweiten Leitungstyp (do2) entgegengesetzt ist.

8. Photodetektoranordnung nach Anspruch 7,
**dadurch gekennzeichnet, dass**
die dritte Schicht (22) einen höheren Schichtwiderstand als die zweite Schicht (21) aufweist.

9. Photodetektoranordnung nach Anspruch 7 oder 8,
**dadurch gekennzeichnet, dass**
die dritte Schicht (22) einen Schichtwiderstand zwischen 10 und 100 kOhm/Quadrat aufweist.

10. Photodetektoranordnung nach einem der Ansprüche 1 bis 9,
**dadurch gekennzeichnet, dass**
einer der Transistoren (45, 46, 47, 48) ausgelegt ist, einen Strompfad von der zweiten Schicht (21) zu dem jeweiligen Messanschluss (24, 25, 26, 27) in einem ersten Betriebszustand zu sperren und in einem zweiten Betriebszustand leitend zu schalten.

**11.** Photodetektoranordnung nach einem der Ansprüche 1 bis 10,
**dadurch gekennzeichnet, dass**
einer der Transistoren (45, 46, 47, 48) als Feldeffekttransistor ausgebildet ist und einen Steueranschluss (29, 30, 31, 32) zur elektrischen Kontaktierung umfasst.

**12.** Photodetektoranordnung nach Anspruch 11,
**dadurch gekennzeichnet, dass**
einer der Transistoren (45, 46, 47, 48) einen Dotierungsbereich umfasst, der den ersten Leitungstyp (do1) aufweist und in der zweiten Schicht (21) an der Grenze zu dem Steueranschluss (29, 30, 31, 32) angeordnet ist.

**13.** Photodetektoranordnung nach Anspruch 11,
**dadurch gekennzeichnet, dass**
ein unmittelbarer Kontakt des Steueranschlusses (29, 30, 31, 32) zu der zweiten Schicht (21) bei einem der Transistoren (45, 46, 47, 48) vorgesehen ist.

**14.** Photodetektoranordnung nach Anspruch 11,
**dadurch gekennzeichnet, dass**
einer der Transistoren (45, 46, 47, 48) eine GateisolatorSchicht (37, 38, 39, 40) aufweist, die zwischen der zweiten Schicht (21) und dem Steueranschluss (29, 30, 31, 32) angeordnet ist.

**15.** Messanordnung, umfassend die Photodetektoranordnung (1) nach einem der Ansprüche 1 bis 14 und eine Schaltungsanordnung (50), die

- mit einem Gesamtstromanschluss (12), welcher auf der ersten Schicht (11) angeordnet ist und an dem ein erstes Potential (V1) abgreifbar ist, und
- mit dem ersten und dem zweiten Messanschluss (24, 25), an dem ein zweites und ein viertes Potential (V2, V4) abgreifbar ist, sowie
- an einem Steuerausgang mit dem ersten und dem zweiten Transistor (45, 46) verbunden ist.

**16.** Messanordnung nach Anspruch 15, sofern dieser auf Anspruch 2 zurückbezogen ist,
**dadurch gekennzeichnet, dass**
die Schaltungsanordnung (50)

- mit dem dritten und dem vierten Messanschluss (26, 27), an dem ein fünftes und ein sechstes Potential (V5, V6) abgreifbar ist, und
- an einem weiteren Steuerausgang mit dem dritten und dem vierten Transistor (46, 47) verbunden ist.

**17.** Verwendung einer Messanordnung nach Anspruch 15 oder 16 zur Bestimmung einer Position des Auftrefffortes einer auf die Photodetektoranordnung (1) auftreffenden Photonenstrahlung (ΦL).

**18.** Verfahren zum Betrieb einer Messanordnung mit einer Photodetektoranordnung (1), umfassend:

- Bestrahlen der Photodetektoranordnung (1) mit einer Photonenstrahlung (ΦL),
- Erzeugen von Elektron-Loch-Paaren in einem Halbleiterkörper (2) der Photodetektoranordnung (1) in Folge der Photonenstrahlung (ΦL),
- Schalten eines ersten und eines zweiten Transistors (45, 46), die eine zweite Schicht (21) an einer zweiten Hauptfläche (20) des Halbleiterkörpers (2) mit einem ersten beziehungsweise einem zweiten Messanschluss (24, 25) koppeln, in einem ersten Betriebszustand in Durchlass und Ermitteln eines ersten und eines zweiten Messstroms (Ia, Ib) sowie
- Schalten des ersten und des zweiten Transistors (45, 46) in einem zweiten Betriebszustand als Sperre.

**19.** Verfahren nach Anspruch 18,
**gekennzeichnet durch**

- Schalten eines dritten und eines vierten Transistors (47, 48), die die zweite Schicht (21) mit einem dritten beziehungsweise einem vierten Messanschluss (26, 27) koppeln, in dem ersten Betriebszustand als Sperre sowie
- Schalten des dritten und des vierten Transistors (47, 48) in dem zweiten Betriebszustand in Durchlass und Ermitteln eines dritten und eines vierten Messstroms (Ic, Id).

FIG. 1A

FIG. 1B

FIG. 2A

FIG. 2 B

EP 1 837 918 A2

FIG. 2C

FIG. 2D

FIG. 2E

# FIG. 3

EP 1 837 918 A2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 8404960 A
- EP 0513444 A1
- US 4874939 A
- US 4887140 A
- US 20040135224 A1